# EUROPEAN PATENT APPLICATION

(11) **EP 0 996 139 A1**
(43) Date of publication of application: **26.04.2000**
(21) Application number: 99120071.8
(22) Date of filing: 19.10.1999
(51) Int. Cl.: H01J 29/07

(54) **Shadow mask and base material therefor**

(30) Priority: 20.10.1998 JP 29797598
(71) Applicant: DAI NIPPON PRINTING CO., LTD., Tokyo 162-0062 (JP)
(72) Inventor: Makita, Akira, 1-chome, Shinjuku-ku Tokyo 162-0062 (JP); Matsumoto, Yutaka, 1-chome, Shinjuku-ku Tokyo 162-0062 (JP)
(74) Representative: VOSSIUS & PARTNER

(57) **Abstract**

A high-definition shadow mask, including a stretched mask, and a base material (1) for a shadow mask, wherein the center line average roughness Ra of the small aperture-side surface is not more than 0.25 µm, and the center line average roughness Ra of the large aperture-side surface is larger than the center line average roughness Ra of the small aperture-side surface by at least 0.25 µm and is not larger than 1 µm.

## Description

The present invention relates to shadow masks, including stretched masks. More particularly, the present invention relates to a shadow mask having a high-definition pattern formed by a predetermined etching process after an extremely smooth surface condition has been formed by carrying out surface treatment, e.g. rolling, chemical polishing, physical polishing, or electrolytic polishing.

Shadow masks, including stretched masks, used in color picture tubes are produced as follows. A surface of a metallic material is coated with a photosensitive resin (photoresist), and the photoresist-coated surface is exposed through a desired pattern brought in vacuum contact with the surface. After a photoresist pattern has been formed in this way, etching is carried out to form desired apertures, holes, etc.

As metallic materials for shadow masks, iron, iron-nickel alloys, iron-nickel-cobalt alloys, and so forth are generally used. These materials are prepared by continuous casting or ingot casting process and then subjected to blooming, hot rolling and cold rolling to produce steel sheets or alloy sheets.

In the etching process, an exposure pattern is brought into vacuum contact with a surface of a metallic material during the exposure process. Therefore, in the case of a material having a smooth surface, because the exposure pattern sticks fast to the surface, the gas trapped in the central portion cannot readily be removed. Thus, it is difficult to effect evacuation.

For this reason, the conventional shadow masks are produced by using metal sheets having surface roughnesses of the order of from 0.20 µm to 0.70 µm in terms of center line average roughness Ra and of the order of 2.0 µm to 4.0 µm in terms of maximum roughness Rₘₐₓ.

Meanwhile, shadow masks used in computer display units for high-definition display are demanded to have a structure in which the pitch of apertures for passing electron beams is small, and the aperture portions are formed with high accuracy. Consequently, metallic materials for such shadow masks need to be subjected to extremely fine etching or other similar processing.

In pattern formation, the larger the amount of etching, the smaller the effect of irregularities formed in the resist pattern; the smaller the amount of etching, the larger the effect of deformation of the resist pattern on etching.

In this regard, a shadow mask for a high-definition display unit is produced by subjecting a base material to fine processing at a small pitch and with a small amount of etching. Therefore, deformation of the resist pattern is reflected in the pattern formed in the base material even more noticeably. Accordingly, there has been a demand for a base material for shadow mask and an etching method, which allow formation of a high-definition pattern.

An object of the present invention is to provide a base material capable of high-definition etching in formation of a high-definition shadow mask and to provide a high-definition shadow mask.

Preferred embodiments of the invention will now be described in connection with the drawings.
Fig. 1 is a diagram for describing the relationship between the roughness of a surface of a base material and a pattern formed thereon.
Fig. 2 is a diagram for describing the relationship between the accuracy of a pattern and transmittance.
Fig. 3 is a sectional view showing an example of an aperture portion of a shadow mask.

The present invention provides a shadow mask wherein the center line average roughness Ra of a small aperture-side surface of the shadow mask is not more than 0.25 µm at a cut-off value of 0.8 mm, and the center line average roughness Ra of a large aperture-side surface of the shadow mask is larger than the center line average roughness Ra of the small aperture-side surface by at least 0.25 µm and is not larger than 1 µm.

In addition, the present invention provides a base material for a shadow mask wherein the center line average roughness Ra of a small aperture-side surface of the base material is not more than 0.25 µm, and the center line average roughness Ra of a large aperture-side surface of the base material is larger than the center line average roughness Ra of the small aperture-side surface by at least 0.25 µm and is not larger than 1 µm.

Preferably, in the shadow mask, the center line average roughness Ra of the small aperture-side surface is in the range of from 0.01 µm to 0.25 µm, and the center line average roughness Ra of the large aperture-side surface is in the range of from 0.26 µm to 1.0 µm.

Preferably, the base material for a shadow mask is a metallic base material having surface roughnesses on both sides thereof adjusted by at least one method selected from among rolling, chemical polishing, physical polishing, and electrolytic polishing.

The present invention is based on the finding that a shadow mask, including a stretched mask, which has particularly excellent characteristics can be obtained by setting the surface roughness of a base material, which is used to form the shadow mask by etching, smaller than that of the conventional base materials, and specifying the small aperture-side surface roughness and further specifying the difference between the small aperture-side surface roughness and the large aperture-side surface roughness.

In general, it is necessary in order to perform fine processing to form a resist pattern of high accuracy on a surface of a base material. Only the present applicant has noticed that the surface roughness of the base material is a factor in hindering the formation of a resist pattern of high accuracy, and proposed a technique as Japanese Patent Application No. 9-3132070.

The present invention will be described below with reference to the accompanying drawings.

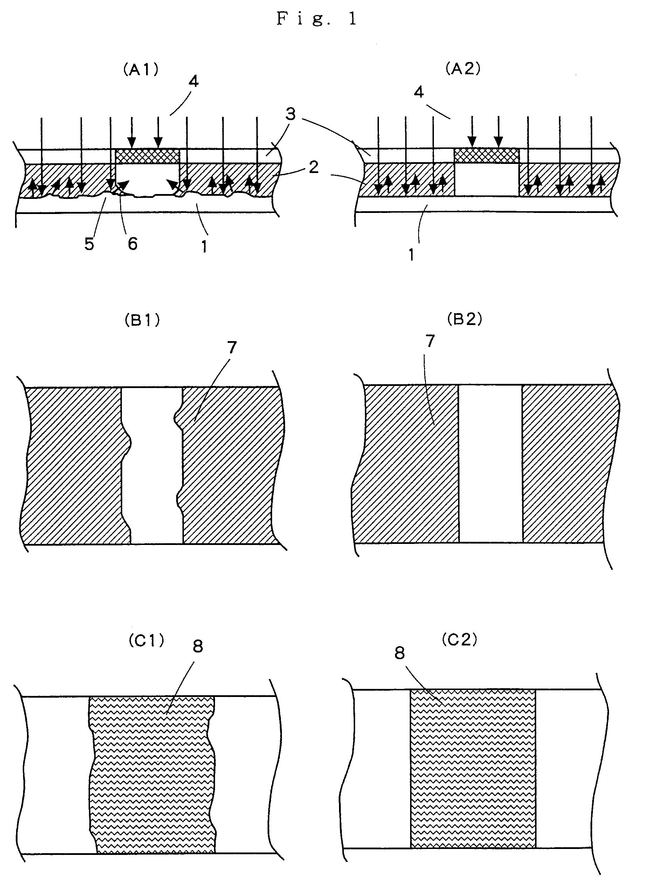

Fig. 1 is a diagram for describing the relationship between the surface roughness of a base material and a pattern formed thereon. Parts (A1), (B1) and (C1) of Fig. 1 show patterns obtained using a base material with a large surface roughness by carrying out etching after the formation of a resist pattern. Parts (A2), (B2) and (C2) of Fig. 1 show patterns similarly formed by using a base material having a small surface roughness.

As shown in the sectional view in part (A1) of Fig. 1, when a surface of a base material 1 having a large surface roughness is coated with a photosensitive resin 2 and exposed to ultraviolet rays 4 with an image pattern 3 placed in close contact with the surface, if there are regions where the surface roughness is large, irregularities 5 locally diffract the exposure light, causing deformed portions 6 to occur in the resulting photosensitive resin pattern. As a result, the resolution of the pattern degrades. In the case of a base material having a small surface roughness, as shown in part (A2) of Fig. 1, a resist pattern free from deformation is obtained.

Parts (B1) and (B2) of Fig. 1 are plan views showing a case where a straight-line pattern is formed. As shown in part (B1) of Fig. 1, when the surface roughness is large, a resist pattern 7 is deformed and cannot accurately be formed in a straight-line shape. When the surface roughness is small, as shown in part (B2) of Fig. 1, a straight-line pattern is obtained.

Parts (C1) and (C2) of Fig. 1 show the shapes of aperture portions 8 formed by etching based on the above-described resist patterns. As shown in part (C1) of Fig. 1, in the case of the deformed resist pattern, irregularities are formed in the aperture portion 8. Therefore, if this is applied to a shadow mask, the irregularities may block off the electron beam, making it difficult to perform accurate irradiation. In the case of the accurate resist pattern, as shown in part (C2) of Fig. 1, an accurate aperture pattern can be formed.

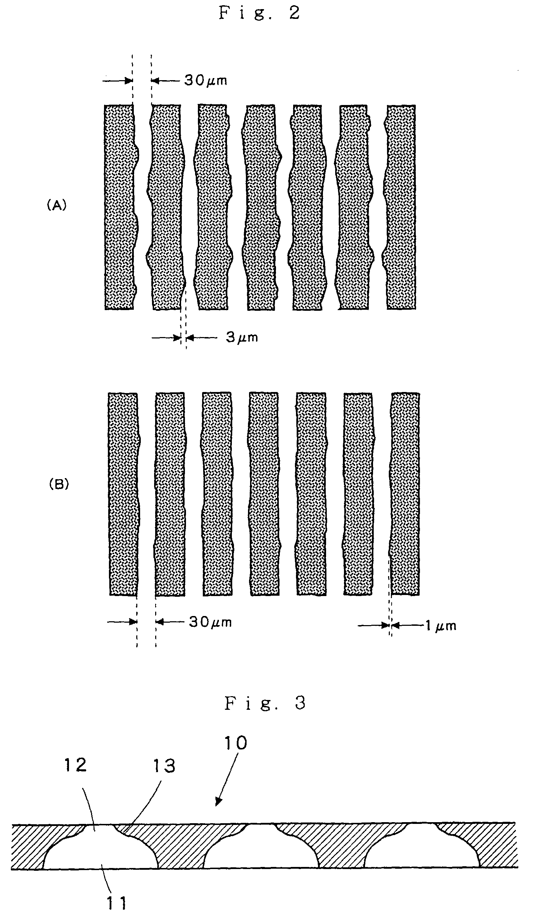

Fig. 2 is a diagram for describing the relationship between the accuracy of a pattern and transmittance.

Let us describe the relationship between the pattern accuracy and transmittance with regard to an aperture grille, by way of example, which has a simple configuration. In the case of an aperture grille having a pitch of 150 µm and an aperture size of 30 µm, the transmittance is 20%. As shown in part (A) of Fig. 2, if there is a deformation of 3 µm on each edge of the tape portion, the transmittance partially reduces by as much as 20%. Accordingly, a CRT using this aperture grille suffers a marked degradation of image quality. If the amount of deformation is of the order of 1.0 µm, as shown in part (B) of Fig. 2, the partial reduction in transmittance is reduced to about 10%, and the image quality degradation is reduced to the utmost extent.

Regarding the similar linearity difference, in the case of an aperture grille having a pitch of 300 µm and an aperture size of 60 µm, the above-described partial differences in transmittance are 10% and 5%, respectively. Thus, the difference in image quality is reduced.

Accordingly, when a high-definition shadow mask is produced by etching, the linearity of the edges of aperture portions is extremely important to the image quality of a CRT using the shadow mask. As the pitch and the aperture size are reduced in order to increase the definition, small dimensional differences between the irregularities on the edges of the aperture portions are reflected in the image quality even more noticeably.

Fig. 3 is a sectional view showing an example of an aperture portion. As shown in the figure, in a shadow mask, the aperture diameter 11 of an aperture portion 10 formed by etching from both sides of a base material is determined by the aperture diameter on the small aperture 12 side, and the aperture condition on the small aperture 12 side affects the display quality. Therefore, the aperture shape on the small aperture 12 side is extremely important in performing high-definition image display. Accordingly, it is important that the surface roughness that affects the aperture shape on the small aperture side during etching should be held within a specified range.

Regarding the surface on the large aperture side, if the surface roughness is set at a small value within a specified range as in the case of the small aperture-side surface roughness, the aperture shape on the large aperture side can also be formed with extremely high accuracy.

However, if the large aperture-side surface roughness is small, a problem occurs. That is, a shadow mask is press-formed in conformity to the shape of the display surface of a CRT before it is fitted to the CRT. In general, before the press forming process, the shadow mask is annealed by heating to a temperature of 600°C to 900°C and thus softened so that the press forming process can be readily performed without producing a crack or the like. In the annealing process, 10 to 50 shadow masks are stacked up and heated in this state. Therefore, if the surface roughness is small, the contact area between each pair of adjacent shadow masks is large, so that diffusion joining may occur on heating, causing the adjacent shadow masks to join together inseparably.

Therefore, in the shadow mask according to the present invention, the large aperture-side surface roughness is set at a value larger than the small aperture-side surface roughness, thereby preventing shadow masks from sticking fast to each other during the anneal-softening process.

More specifically, the small aperture-side surface roughness is set at a value not larger than 0.25 µm in terms of the center line average roughness Ra specified in ISO 468-1982, ISO 3274-1975, ISO 4287/1-1984, ISO 4287/2-1984 and ISO 4288-1985, which is measured with a stylus-type shape-measuring apparatus (e.g. Tarysurf 6, manufactured by Rank Taylor Hobson Limited) at a cut-off value of 0.8 mm, and the large aperture-side surface roughness Ra specified in said ISO standards is set at a value larger than the small aperture-side surface roughness Ra by at least 0.25 µm.

The large aperture-side surface roughness affects the aperture shape of the large apertures. That is, as the large aperture-side surface roughness becomes larger, the large-aperture shape becomes worse. Therefore, it is necessary that the large aperture-side surface roughness be not larger than 1 µm. It is preferable that the small aperture-side surface roughness be in the range of from 0.01 µm to 0.25 µm, and the large aperture-side surface roughness be in the range of from 0.26 µm to 1.0 µm. It is particularly preferable that the large aperture-side surface roughness be in the range of from 0.55 µm to 0.75 µm.

The base material according to the present invention can be produced by a method wherein each surface of a steel sheet produced by rolling a steel ingot is rolled by using a roll having an adjusted surface roughness to obtain a predetermined roughness for the surface. The base material can also be produced by a method wherein each surface of a rolled steel sheet is polished by physical polishing using an abrasive material, chemical polishing, electrolytic polishing, etc. More specifically, in the case of physical polishing, the base material can be produced by buffing or a polishing method using a roll abrasive material or a film abrasive material. The polishing method using a roll abrasive material or a film abrasive material is particularly preferable because no powder particles are brought into the subsequent process.

In a case where the surface roughness is adjusted by using an etching liquid, it is possible to use an etching liquid higher in concentration than an etching liquid used to form a pattern by etching. More specifically, a highly concentrated ferric chloride solution of 50° Bh (Baume degree of heavy liquid) or higher can be used.

Examples of base materials usable in the present invention are an iron-nickel alloy, an iron-nickel-cobalt alloy, and a low-carbon steel.

To produce a shadow mask by etching, an exposure pattern is brought into vacuum contact with a surface of a base material in the exposure process. When the base material has a smooth surface, the exposure pattern sticks fast to the surface. Therefore, the gas trapped in the central portion cannot readily be removed, and thus it is difficult to effect evacuation. For this reason, the conventional practice is to use metal sheets having surface roughnesses of the order of from 0.20 µm to 0.70 µm in terms of center line average roughness Ra and of the order of 2.0 µm to 4.0 µm in terms of maximum roughness Rₘₐₓ. However, the problem of contact failure in the vacuum contact can be solved by using one of apparatuses proposed by the present applicant, for example, in Japanese Patent Application Unexamined Publication (KOKAI) Nos. 3-265835, 3-265836 and 3-265837.

More specifically, two pressure-controllable vacuum chambers are independently provided at both sides of an exposure pattern to perform evacuation from both sides of the exposure pattern. Therefore, the exposure pattern is brought into contact with the base material from the center thereof by a pressure difference produced across the exposure pattern. Accordingly, it is possible to prevent formation of a space which might otherwise be formed by the gas remaining in the central portion of the exposure pattern.

The present invention will be described below more specifically by way of examples.

### Examples and Comparative Examples:

The surfaces of a 0.12-mm thick cold-rolled base material having different surface roughnesses on the obverse and reverse sides thereof were subjected to degreasing and rinsing and then coated with a photoresist consisting essentially of casein containing 1% by weight of ammoniuim dichromate so that the thickness of the photoresist after drying would be 5 µm. Then, the coated photoresist was dried.

Next, two-stage etching process was carried out to prepare a shadow mask having dot apertures 120 µm in diameter arrayed in the shape of a regular triangle of 0.28 mm.

The shape of the apertures thus obtained was evaluated by measuring the diameters of 80 apertures and obtaining an aperture diameter deviation σ. The results of the measurement are shown in Table 1 below. The aperture diameter was obtained by (maximum diameter-minimum diameter)/2 for each individual aperture measured with an autofocus depth gauge (LFM-2500, manufactured by Union Optics).

Regarding the surface roughness, the center line average roughness Ra specified in ISO 468-1982, ISO 3274-1975, ISO 4287/1-1984, ISO 4287/2-1984 and ISO 4288-1985 was measured with a stylus-type shape-measuring apparatus (e.g. Tarysurf 6, manufactured by Rank Taylor Hobson Limited) at a cut-off value of 0.8 mm.

20 shadow masks having the same surface roughnesses were stacked up and annealed by heating for 15 minutes at 800°C in an atmosphere of hydrogen and nitrogen mixed in the ratio of 1:9 (volume ratio) with a dew point of 10°C. Then, the heat-treated shadow masks were checked for occurrence of joining between a pair of adjacent shadow masks.

**Table 1**

| | Large aperture side Ra (µm) | Small aperture side Ra (µm) | Difference in Ra between two sides (µm) | Aperture diameter σ (µm) | Joining |
|---|---|---|---|---|---|
| Example 1 | 0.62 | 0.15 | 0.47 | 0.35 | none |
| Example 2 | 0.75 | 0.20 | 0.55 | 0.39 | none |
| Comp.Ex.1 | 0.56 | 0.52 | 0.04 | 0.58 | none |
| Comp.Ex.2 | 0.18 | 0.15 | 0.03 | 0.37 | occurred |
| Comp.Ex.3 | 0.15 | 0.49 | 0.34 | 0.54 | none |
| Comp.Ex.4 | 0.32 | 0.15 | 0.17 | 0.39 | occurred |
| Comp.Ex.5 | 0.18 | 0.40 | 0.22 | 0.51 | occurred |
| Comp.Ex.6 | 1.12 | 0.20 | 0.92 | 0.55 | none |

As has been stated above, in the present invention, the etching base material has different surface roughnesses on the obverse and reverse sides thereof, which are set within predetermined ranges, respectively, thereby obtaining favorable aperture shapes on both the small and large aperture sides. In addition, it is possible to prevent joining of shadow masks by thermal diffusion during annealing in a CRT manufacturing process. Thus, it is possible to obtain high-quality shadow masks for high-definition display.

## Claims

1. A shadow mask wherein a center line average roughness Ra of a small aperture-side surface of said shadow mask is not more than 0.25 µm at a cut-off value of 0.8 mm, and a center line average roughness Ra of a large aperture-side surface of said shadow mask is larger than said center line average roughness Ra of the small aperture-side surface by at least 0.25 µm and is not larger than 1 µm.

2. A base material for a shadow mask wherein a center line average roughness Ra of a small aperture-side surface of said base material is not more than 0.25 µm at a cut-off value of 0.8 mm, and a center line average roughness Ra of a large aperture-side surface of said base material is larger than said center line average roughness Ra of the small aperture-side surface by at least 0.25 µm and is not larger than 1 µm.

3. A shadow mask according to claim 1, wherein said center line average roughness Ra of the small aperture-side surface is in a range of from 0.01 µm to 0.25 µm, and said center line average roughness Ra of the large aperture-side surface is in a range of from 0.26 µm to 1.0 µm.

4. A base material for a shadow mask according to claim 2, wherein said center line average roughness Ra of the small aperture-side surface is in a range of from 0.01 µm to 0.25 µm, and said center line average roughness Ra of the large aperture-side surface is in a range of from 0.26 µm to 1.0 µm.

5. A shadow mask according to claim 1 or 3, comprising a metallic base material having surface roughnesses on both sides thereof adjusted by at least one method selected from among rolling, chemical polishing, physical polishing, and electrolytic polishing.

6. A base material for a shadow mask according to claim 2 or 4, which is a metallic base material having surface roughnesses on both sides thereof adjusted by at least one method selected from among rolling, chemical polishing, physical polishing, and electrolytic polishing.
